# EUROPEAN PATENT APPLICATION

(11) **EP 4 650 968 A2**
(43) Date of publication of application: **19.11.2025**
(21) Application number: 25205177.6
(22) Date of filing: 29.09.2025
(51) Int. Cl.: G06F 11/273

(54) **PROTECTION CIRCUIT AND METHOD FOR PROTECTING PROTECTED MODULE, STORAGE MEDIUM, AND ELECTRONIC DEVICE**

(30) Priority: 31.10.2024 CN 202411549486
(71) Applicant: Horizon Journey (Shanghai) Technology Co., Ltd., Shanghai 201306 (CN)
(72) Inventor: LI, Jing, Shanghai, 201306 (CN); LI, Wenxing, Shanghai, 201306 (CN); YANG, Bin, Shanghai, 201306 (CN); YANG, Ruiqi, Shanghai, 201306 (CN); CHEN, Chen, Shanghai, 201306 (CN)
(74) Representative: v. Bezold & Partner Patentanwälte - PartG mbB

(57) **Abstract**

Disclosed are a protection circuit and method for protecting a protected module, a storage medium, and an electronic device. The protection circuit for a protected module includes: a first detection control module, configured for determining a current state of the protected module based on a transmission signal on a control signal bus between a real control signal source and the protected module; a generation module, configured for generating test input data in response to the current state being an idle state; and a second detection control module, configured for determining an abnormality detection result for the protected module based on actual test output data output by the protected module for the test input data and expected test output data corresponding to the test input data. The embodiments of the present disclosure can effectively achieve abnormality detection on the protected module without impacting normal operation of the protected module.

## Description

### FIELD OF THE INVENTION

This disclosure relates to functional safety technology, and in particular, to a protection circuit and method for protecting a protected module, a storage medium, and an electronic device.

### BACKGROUND OF THE INVENTION

At present, chips are applied widely. To guarantee chip reliability, it is often needed to perform abnormality detection on a module in a chip. How to effectively implement abnormality detection on the module in the chip is a problem worthy of attention of a person of ordinary skill in the art.

### SUMMARY OF THE INVENTION

To solve the above technical problem, this disclosure provides a protection circuit and method for protecting a protected module, a storage medium, and an electronic device.

Based on an aspect of embodiments of this disclosure, a protection circuit for a protected module is provided, and includes:
a first detection control module, configured for determining a current state of the protected module based on a transmission signal on a control signal bus between a real control signal source and the protected module;
a generation module, configured for generating test input data in response to the current state being an idle state; and
a second detection control module, configured for determining an abnormality detection result for the protected module based on actual test output data output by the protected module for the test input data and expected test output data corresponding to the test input data.

Based on another aspect of embodiments of this disclosure, a method for protecting a protected module is provided, and includes:
determining a current state of the protected module based on a transmission signal on a control signal bus between a real control signal source and the protected module;
generating test input data in response to the current state being an idle state; and
determining an abnormality detection result for the protected module based on actual test output data output by the protected module for the test input data and expected test output data corresponding to the test input data.

According to yet another aspect of embodiments of this disclosure, a computer readable storage medium is provided. The storage medium stores thereon a computer program. The computer program is configured for implementing the method for protecting a protected module described above.

According to still another aspect of embodiments of this disclosure, an electronic device is provided, where the electronic device includes:
a processor; and
a memory configured to store processor-executable instructions.

The processor is configured to read the executable instructions from the memory, and execute the instructions to implement the method for protecting a protected module described above.

According to still another aspect of embodiments of this disclosure, a computer program product is provided. When instructions in the computer program product are executed by a processor, the method for protecting a protected module described above is implemented.

According to a protection circuit and method for protecting a protected module, a storage medium, an electronic device, and a program product according to embodiments of this disclosure, the first detection control module may determine the current state of the protected module. In case the current state of the protected module is the idle state, the generation module may generate the test input data. The second detection control module may obtain the actual test output data output by the protected module for the test input data. The second detection control module further may determine the expected test output data corresponding to the test input data. Note that if there is no abnormality in the protected module, the expected test output data and the actual test output data generally are the same, and if there is an abnormality in the protected module, the expected test output data and the actual test output data generally are inconsistent. In view of this, it may be inferred, by referring to consistency between the expected test output data and the actual test output data, whether there is any abnormality in the protected module, thereby obtaining the abnormality detection result for the protected module. It can be seen that, by using the protection circuit, abnormality detection can be performed on the protected module during an intermittent period of normal operation of the protected module. In this way, it is enabled to effectively implement abnormality detection on the protected module without impacting normal operation of the protected module.

### BRIEF DESCRIPTION OF THE DRAWINGS

FIG. 1 is a diagram of architecture of a system applicable to some illustrative embodiments of this disclosure.
FIG. 2 is a protection circuit for a protected module according to some illustrative embodiments of this disclosure.
FIG. 3 is a protection circuit for a protected module according to some other illustrative embodiments of this disclosure.
FIG. 4 is a flowchart of a method for protecting a protected module according to some illustrative embodiments of this disclosure.
FIG. 5 is a flowchart of a method for protecting a protected module according to some other illustrative embodiments of this disclosure.
FIG. 6 is a flowchart of a method for generating signal conflict indication information according to some illustrative embodiments of this disclosure.
FIG. 7 is a flowchart of a method for protecting a protected module according to yet some other illustrative embodiments of this disclosure.
FIG. 8 is a schematic diagram of a structure of an electronic device according to some illustrative embodiments of this disclosure.

### DETAILED DESCRIPTION OF THE EMBODIMENTS

To explain this disclosure, illustrative embodiments of this disclosure are elaborated below with reference to accompanying drawings. Clearly, the embodiments described are merely some, rather than all, embodiments of this disclosure. It should be understood that this disclosure is not limited to the illustrative embodiments.

It should be noted that unless otherwise specified, the scope of this disclosure is not limited to relative arrangements, numeric expressions, and numerical values of components and steps described in these embodiments.

### Disclosure overview

At present, chips are applied widely. For example, a chip is applicable to a vehicle, in which case, the chip may be an intelligent driving chip.

To guarantee chip reliability, it is often needed to perform abnormality detection on a module in a chip. For example, the chip may include a data path, to guarantee chip reliability, abnormality detection may be performed on a module in the data path. Optionally, the data path may include but is not limited to an image path, a voice path, etc.

A module in a chip for which abnormality detection is needed may be referred to as a protected module. How to effectively implement abnormality detection on the protected module is a problem worthy of attention of a person of ordinary skill in the art.

### Illustrative system

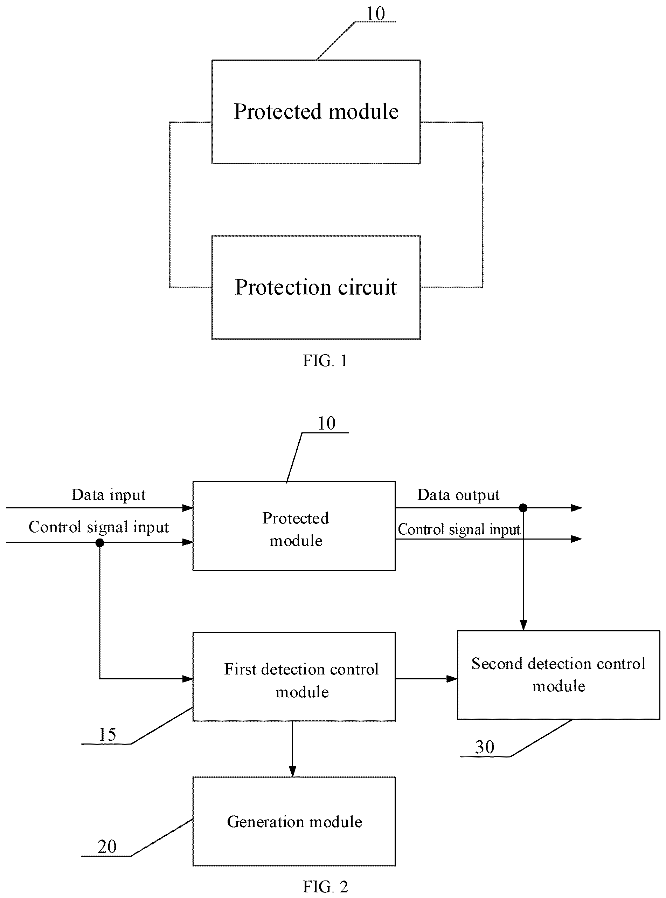

As shown in FIG. 1, with embodiments of this disclosure, a protecting protection circuit for protecting the protected module 10 may be provided outside the protected module 10.

Optionally, the protected module 10 may be a circuit or a device having a storage function. For example, the protected module 10 may be a circuit or a device having a storage function in a data path included in the chip. As an example, the protected module 10 may be a static random-access memory (SRAM) in the data path. Alternatively, the protected module 10 may be a register group in the data path. In addition, based on the storage function the protected module 10 has, the protected module 10 may be configured for storing image data, voice data, etc. Alternatively, based on the storage function the protected module 10 has, the protected module 10 may be configured for storing a computer executable instruction.

In embodiments of this disclosure, by using the protection circuit, abnormality detection, such as permanent abnormality detection can be performed on the protected module 10 during an intermittent period of normal operation of the protected module 10. In this way, it is enabled to effectively implement abnormality detection on the protected module 10 without impacting normal operation of the protected module 10.

### Illustrative circuit

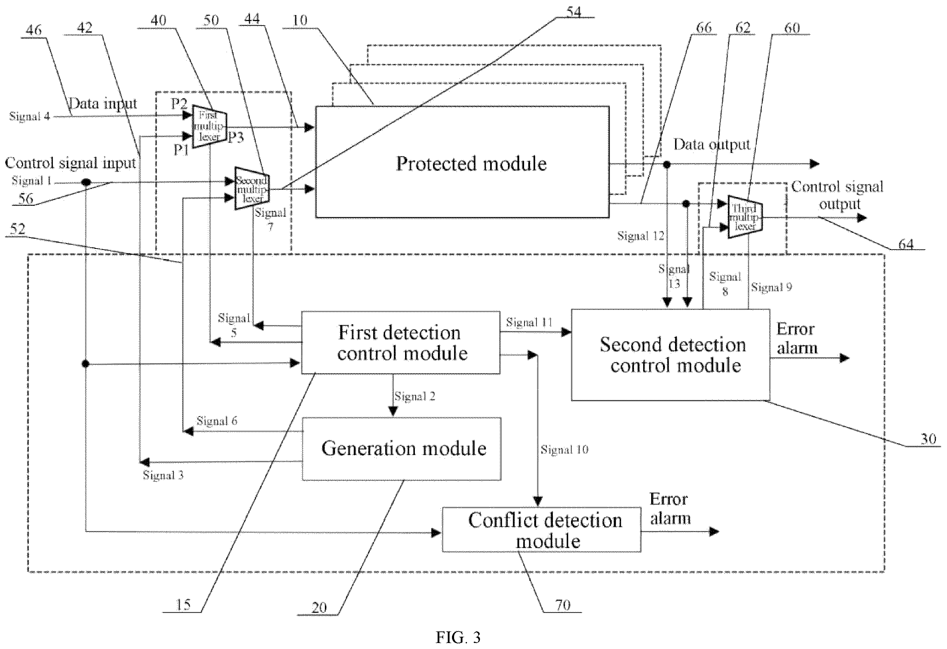

FIG. 2 is a schematic diagram of a structure of a protection circuit for a protected module 10 according to some illustrative embodiments of this disclosure. FIG. 3 is a schematic diagram of a structure of a protection circuit for a protected module 10 according to some other illustrative embodiments of this disclosure.

Optionally, the protected module 10 may be a circuit or a device having a storage function in a data path included in a chip. Using the protection circuit, it is enabled to perform abnormality detection on an entire storage space, or some of the storage space, of the protected module 10. To facilitate understanding, hereinafter the specification takes the case of performing abnormality detection on the entire storage space of the protected module 10 using the protection circuit as an example.

As shown in FIG. 2 and FIG. 3, the protection circuit may include:
a first detection control module 15, configured for determining a current state of the protected module 10 based on a transmission signal on a control signal bus between a real control signal source and the protected module 10;
a generation module 20, configured for generating test input data in response to the current state being an idle state; and
a second detection control module 30, configured for determining an abnormality detection result for the protected module 10 based on actual test output data output by the protected module 10 for the test input data and expected test output data corresponding to the test input data.

Optionally, the real control signal source may be a module configured for providing the protected module 10 with a real input control signal. The real control signal source may be located inside or outside the chip where the protected module 10 is located. The real input control signal may be a control signal needed for normal operation of the protected module 10. The real input control signal also may be referred to as an external input control signal. As an example, the real input control signal may be a signal 1 in FIG. 3.

Optionally, the first detection control module 15 may be a module having a certain control function and configured for detecting a state of the protected module 10. A control signal bus may be set between the real control signal source and the protected module 10, and the first detection control module 15 may be in electrical connection with the control signal bus. In this way, the first detection control module 15 may obtain a transmission signal on the control signal bus, and determine a current state of the protected module 10 based on the obtained transmission signal. The current state of the protected module 10 may include two cases, respectively being an operating state and an idle state. The current state of the protected module 10 being the operating state may be understood as that the protected module 10 currently is to execute a real task, such as that the protected module 10 is to execute a real data reading and/or writing task. The current state of the protected module 10 being the idle state may be understood as that the protected module 10 currently has no real task to execute. If the current state of the protected module 10 is the idle state, it may be considered that the protected module 10 is currently in an intermittent period of normal operation.

Optionally, the generation module 20 may be a module configured for generating abnormality detection related data and signal. The generation module 20 may be in electrical connection with the first detection control module 15. The generation module 20 further may be in electrical connection with the protected module 10. If the current state of the protected module 10 is the idle state, the first detection control module 15 may send a trigger signal to the generation module 20, to trigger generating the test input data by the generation module 20. As an example, the trigger signal may be a signal 2 in FIG. 3. In addition, the entire storage space of the protected module 10 may include M bits, the test input data may include input characters corresponding respectively to the M bits. Any one input character may be "0" or "1". The generation module 20 may transmit the generated test input data to the protected module 10. The test input data may first be written in the protected module 10, and then be read from the protected module 10, wherein a read result may be taken as the actual test output data output by the protected module 10 for the test input data. The actual test output data may include actual output characters corresponding respectively to the M bits.

Optionally, the second detection control module 30 may be a module having a certain control function and configured for determining whether there is any abnormality in the protected module 10. The second detection control module 30 may be in electrical connection with the protected module 10. In this way, the second detection control module 30 may obtain the actual test output data. The second detection control module 30 further may determine the expected test output data corresponding to the test input data. The expected test output data may include expected output characters corresponding respectively to the M bits. If the protected module 10 is a module having a data storage function, in theory, data output by the protected module 10 are the same as data input to the protected module 10. Then, the expected test output data may remain the same as the test input data. Based on the actual test output data and the expected test output data, the second detection control module 30 may determine the abnormality detection result for the protected module 10. For example, if the actual test output data are the same as the expected test output data, the abnormality detection result may denote that there is no abnormality in the protected module 10. If the actual test output data are inconsistent with the expected test output data, the abnormality detection result may denote that there is an abnormality in the protected module 10. If the abnormality detection result denotes an abnormality in the protected module 10, the second detection control module 30 may send an alarm about abnormality.

In an example, abnormality detection on the protected module 10 may be implemented based on a memory built-in-self-test (MBIST) algorithm. The MBIST algorithm may include but is not limited to a March C algorithm, a March C+ algorithm, a March C- algorithm, a MATS+ algorithm, etc. Taking the MBIST algorithm being the March C algorithm as an example, operation of a first round of data reading and writing may first be performed. The first round of data reading and writing may refer to: writing 0 in the M bits of the protected module 10 according to a rule of ascending address order, and once the 0-writing is done, reading the M bits according to the rule of ascending address order. Once operation of the first round of data reading and writing is done, operation of a second round of data reading and writing may be performed. The operation of the second round of data reading and writing may refer to: writing 1 in the M bits of the protected module 10 according to the rule of ascending address order, and once the 1-writing is done, reading the M bits according to the rule of ascending address order. Once operation of the second round of data reading and writing is done, operation of a third round of data reading and writing may be performed. The operation of the third round of data reading and writing may refer to: writing 0 in the M bits of the protected module 10 according to the rule of ascending address order, and once the 0-writing is done, reading the M bits according to the rule of ascending address order. Once operation of the third round of data reading and writing is done, operation of a fourth round of data reading and writing may be performed. The operation of the fourth round of data reading and writing may refer to: writing 0 in the M bits of the protected module 10 according to a rule of descending address order, and once the 0-writing is done, reading the M bits according to rule of descending address order. Once operation of the fourth round of data reading and writing is done, operation of a fifth round of data reading and writing may be performed. The operation of the fifth round of data reading and writing may refer to: writing 1 in the M bits of the protected module 10 according to the rule of descending address order, and once the 1-writing is done, reading the M bits according to the rule of descending address order. Operations of a number of rounds of data reading and writing further may again be performed subsequently, and are not elaborated one by one here. If in operation of the first round of data reading and writing, M 0s are read in sequence from the M bits; in operation of the second round of data reading and writing, M 1s are read in sequence from the M bits; in operation of the third round of data reading and writing, M 0s are read in sequence from the M bits; in operation of the fourth round of data reading and writing, M 0s are read in sequence from the M bits; in operation of the fifth round of data reading and writing, M 1s are read in sequence from the M bits; ..., it may be determined that the actual test output data are the same as the expected test output data. Then, the abnormality detection result determined by the second detection control module 30 may denote that there is no abnormality in the protected module 10.

In embodiments of this disclosure, the first detection control module 15 may determine the current state of the protected module 10. In case the current state of the protected module 10 is the idle state, the generation module 20 may generate the test input data. The second detection control module 30 may obtain the actual test output data output by the protected module 10 for the test input data. The second detection control module 30 further may determine the expected test output data corresponding to the test input data. Note that if there is no abnormality in the protected module 10, the expected test output data and the actual test output data generally are the same, and if there is an abnormality in the protected module 10, the expected test output data and the actual test output data generally are inconsistent. In view of this, it may be inferred, by referring to consistency between the expected test output data and the actual test output data, whether there is any abnormality in the protected module 10, thereby obtaining the abnormality detection result for the protected module 10. It may be seen that using the protection circuit, it is enabled to perform, in an intermittent period of normal operation of the protected module 10, abnormality detection on the protected module 10. In this way, it is enabled to effectively implement abnormality detection on the protected module 10 without impacting normal operation of the protected module 10.

In some optional examples, as shown in FIG. 3, the protection circuit further may include:
a first multiplexer 40, configured for conducting, in a first mode, a data signal bus between the generation module 20 and the protected module 10.

The first detection control module 15 is configured for, in response to the current state being the idle state, setting the first multiplexer 40 to the first mode, to enable the protected module 10 to receive the test input data generated by the generation module 20.

Optionally, a multiplexer involved in embodiments of this disclosure also may be referred to as a MUX.

Optionally, the first multiplexer 40 may be configured for including a plurality of modes. The plurality of modes may include a first mode. In the first mode, the first multiplexer 40 may conduct the data signal bus between the generation module 20 and the protected module 10. In a mode other than the first mode, the first multiplexer 40 may not conduct the data signal bus between the generation module 20 and the protected module 10. The data signal bus between the generation module 20 and the protected module 10 may include a bus 42 and a bus 44 in FIG. 3.

Optionally, the first detection control module 15 may be in electrical connection with the first multiplexer 40. The first multiplexer 40 may be in electrical connection with the protected module 10 and the generation module 20, respectively. If the current state of the protected module 10 is the idle state, the first detection control module 15 may set the first multiplexer 40 to the first mode. In this way, the data signal bus between the generation module 20 and the protected module 10 may be conducted. Accordingly, the test input data generated by the generation module 20 may be transmitted through the data signal bus to the protected module 10. That is, the protected module 10 may receive the test input data, based on which, the protected module 10 may output the actual test output data, to be used for determining the abnormality detection result for the protected module 10. As an example, the test input data may be carried by a signal 3 in FIG. 3.

In embodiments of this disclosure, in case the current state of the protected module 10 is the idle state, by setting the first multiplexer 40 to the first mode adapted to the idle state, the test input data generated by the generation module 20 are enabled to be successfully transmitted to the protected module 10, which facilitates implementing abnormality detection on the protected module 10 using an intermittent period of normal operation of the protected module 10.

In some optional examples, as shown in FIG. 3, the protection circuit further may include:
a first multiplexer 40, configured for conducting, in a second mode, a data signal bus between a real data source and the protected module 10.

The first detection control module 15 is configured for, in response to the current state being an operating state, setting the first multiplexer 40 to the second mode, to enable the protected module 10 to receive real input data coming from the real data source.

Optionally, the real data source may be a module configured for providing the protected module 10 with the real input data. The real data source may be located inside or outside the chip where the protected module 10 is located. The real input data may be input data needed for normal operation of the protected module 10. A data type of the real input data may include but is not limited to an image type, a feature map type, a weight type, etc. As an example, the real input data may be carried by a signal 4 in FIG. 3.

Optionally, the first multiplexer 40 may be configured for including a plurality of modes. In addition to including the first mode, the plurality of modes further may include a second mode. In the second mode, the first multiplexer 40 may conduct the data signal bus between the real data source and the protected module 10. In a mode other than the second mode, the first multiplexer 40 may not conduct the data signal bus between the real data source and the protected module 10. The data signal bus between the real data source and the protected module 10 may include a bus 46 and the bus 44 shown in FIG. 3.

If the current state of the protected module 10 is the operating state, the first detection control module 15 may put the first multiplexer 40 in the second mode. In this way, the data signal bus between the real data source and the protected module 10 can be conducted. Accordingly, the real input data at the real data source may be transmitted through the data signal bus to the protected module 10. That is, the protected module 10 may receive the real input data. The real input data may first be written in the protected module 10, and then be read from the protected module 10, where a read result may be transmitted to a post-stage module of the protected module 10.

In embodiments of this disclosure, in case the current state of the protected module 10 is the operating state, by setting the first multiplexer 40 to the second mode adapted to the operating state, the real input data at the real data source are enabled to be successfully transmitted to the protected module 10, which facilitates guaranteeing normal operation of the protected module 10.

In an example, as shown in FIG. 3, the first multiplexer 40 may include a first input P1, a second input P2, and an output P3. The first input P1 may be in electrical connection with the generation module 20. The second input P2 may be in electrical connection with the real data source. The output P3 may be in electrical connection with the protected module 10. The first detection control module 15 may generate a signal, such as a signal 5 in FIG. 3, configured for controlling a mode of the first multiplexer 40. If the current state of the protected module 10 is the idle state, the signal 5 may be configured for conducting a connection between the first input P1 and the output P3, in which case the connection between the bus 42 and the bus 44 may be conducted, and the first multiplexer 40 is set to the first mode. If the current state of the protected module 10 is the operating state, the signal 5 may be configured for conducting a connection between the second input P2 and the output P3, in which case the connection between the bus 46 and the bus 44 may be conducted, and the first multiplexer 40 is put in the second mode. In this way, it is enabled to efficiently and quickly put the first multiplexer 40 in a respective mode as needed.

A principle of controlling the mode of the first multiplexer 40 is introduced in last paragraph; a principle of controlling a mode of a remaining multiplexer involved in embodiments of this disclosure is similar, and is not introduced in detail hereinafter.

In some optional examples, as shown in FIG. 3, the protection circuit further may include:
a second multiplexer 50, configured for conducting, in a third mode, a control signal bus between the generation module 20 and the protected module 10 the control signal bus.

The generation module 20 is configured for, in response to the current state being the idle state, generating a test input control signal corresponding to the test input data.

The first detection control module 15 is configured for, in response to the current state being the idle state, setting the second multiplexer 50 to the third mode, to enable the protected module 10 to receive the test input control signal generated by the generation module 20.

Optionally, the second multiplexer 50 may be configured for including a plurality of modes. The plurality of modes may include a third mode. In the third mode, the second multiplexer 50 may conduct the control signal bus between the generation module 20 and the protected module 10. In a mode other than the third mode, the second multiplexer 50 may not conduct the control signal bus between the generation module 20 and the protected module 10. The control signal bus between the generation module 20 and the protected module 10 may include a bus 52 and a bus 54 in FIG. 3.

Optionally, the first detection control module 15 may be in electrical connection with the second multiplexer 50. The second multiplexer 50 may be in electrical connection with the protected module 10 and the generation module 20, respectively. If the current state of the protected module 10 is the idle state, the first detection control module 15 may send a trigger signal to the generation module 20, to trigger generating the test input data and the test input control signal by the generation module 20. The test input control signal may be a control signal matching the test input data. As an example, the test input control signal may include but is not limited to a control signal configured for instructing to start transmitting the test input data, a control signal configured for indicating use of a rule of ascending addresses order or of a rule descending addresses order, etc. The test input control signal for example may be a signal 6 in FIG. 3. If the current state of the protected module 10 is the idle state, the first detection control module 15 may put the second multiplexer 50 in the third mode. For example, the first detection control module 15 may put the second multiplexer 50 in the third mode using a signal 7 in FIG. 3. In this way, the control signal bus between the generation module 20 and the protected module 10 may be conducted. Accordingly, the test input control signal generated by the generation module 20 may be transmitted through the control signal bus to the protected module 10. That is, the protected module 10 may receive the test input control signal, and the protected module 10 may run based on the test input control signal, which thus facilitates guaranteeing that abnormality detection is performed normally on the protected module 10.

In some optional examples, as shown in FIG. 3, the protection circuit further may include:
a second multiplexer 50, configured for conducting, in a fourth mode, the control signal bus between the real control signal source and the protected module 10.

The first detection control module 15 is configured for, in response to the current state being an operating state, setting the second multiplexer 50 to the fourth mode, to enable the protected module 10 to receive a real input control signal coming from the real control signal source.

Optionally, the second multiplexer 50 may be configured for including a plurality of modes. In addition to including the third mode, the plurality of modes further may include a fourth mode. In the fourth mode, the second multiplexer 50 may conduct the control signal bus between the real control signal source and the protected module 10. In a mode other than the fourth mode, the second multiplexer 50 may not conduct the control signal bus between the real control signal source and the protected module 10. The control signal bus between the real control signal source and the protected module 10 may include a bus 56 and the bus 54 shown in FIG. 3.

If the current state of the protected module 10 is the operating state, the first detection control module 15 may put the second multiplexer 50 in the fourth mode. For example, the first detection control module 15 may put the second multiplexer 50 in the fourth mode using the signal 7 in FIG. 3. In this way, the control signal bus between the real control signal source and the protected module 10 may be conducted. Accordingly, the real input control signal at the real control signal source may be transmitted through the control signal bus to the protected module 10. That is, the protected module 10 may receive the real input control signal, to be used for normal operation of the protected module 10.

In embodiments of this disclosure, in case the current state of the protected module 10 is the operating state, by setting the second multiplexer 50 to the fourth mode adapted to the operating state, the real input control signal at the real control signal source are enabled to be successfully transmitted to the protected module 10, which facilitates guaranteeing normal operation of the protected module 10.

In some optional examples, as shown in FIG. 3, the protection circuit further may include:
a third multiplexer 60, configured for conducting, in a fifth mode, a control signal bus between the second detection control module 30 and a post-stage module of the protected module 10.

The second detection control module 30 is configured for generating an output blocking control signal, and in response to the current state being the idle state, setting the third multiplexer 60 to the fifth mode, to enable the post-stage module to receive the output blocking control signal generated by the second detection control module 30, such that in response to the output blocking control signal, the post-stage module blocks the actual test output data which are output by the protected module 10 for the test input data.

Optionally, the third multiplexer 60 may be configured for including a plurality of modes. The plurality of modes may include a fifth mode. In the fifth mode, the third multiplexer 60 may conduct the control signal bus between the second detection control module 30 and the post-stage module of the protected module 10. In a mode other than the fifth mode, the third multiplexer 60 may not conduct the control signal bus between the second detection control module 30 and the post-stage module. The control signal bus between the second detection control module 30 and the post-stage module may include a bus 62 and a bus 64.

Optionally, the second detection control module 30 may be in electrical connection with the third multiplexer 60. The third multiplexer 60 further may be in electrical connection with the protected module 10 and the post-stage module, respectively. If the current state of the protected module 10 is the idle state, the second detection control module 30 may generate the output blocking control signal, such as a signal 8 in FIG. 3, wherein the output blocking control signal may be configured for instructing blocking of the actual test output data which are output by the protected module 10. If the current state of the protected module 10 is the idle state, the second detection control module 30 further may put the third multiplexer 60 in the fifth mode. For example, the second detection control module 30 may put the third multiplexer 60 in the fifth mode using a signal 9 in FIG. 3. In this way, the control signal bus between the second detection control module 30 and the post-stage module may be conducted. Accordingly, the output blocking control signal generated by the second detection control module 30 may be transmitted through the control signal bus to the post-stage module. In response to receiving the output blocking control signal, the post-stage module may block the actual test output data. For example, the post-stage module may not receive the actual test output data.

In embodiments of this disclosure, in case the current state of the protected module 10 is the idle state, by setting the third multiplexer 60 to the fifth mode adapted to the idle state, the post-stage module may block the actual test output data, which facilitates avoiding resource and power consumption needed for receiving the actual test output data.

In some optional examples, as shown in FIG. 3, the protection circuit further may include:
a third multiplexer 60, configured for conducting, in a sixth mode, a control signal bus between the protected module 10 and a post-stage module of the protected module 10.

The second detection control module 30 is configured for in response to the current state being an operating state, setting the third multiplexer 60 to the sixth mode, to enable the post-stage module to receive a real output control signal output by the protected module 10.

Optionally, the third multiplexer 60 may be configured for including a plurality of modes. In addition to including the fifth mode, the plurality of modes may include a sixth mode. In the sixth mode, the third multiplexer 60 may conduct the control signal bus between the protected module 10 and the post-stage module of the protected module 10. In a mode other than the sixth mode, the third multiplexer 60 may not conduct the control signal bus between the protected module 10 and the post-stage module. The control signal bus between the protected module 10 and the post-stage module may include the bus 64 and a bus 66.

If the current state of the protected module 10 is the operating state, the second detection control module 30 may set the third multiplexer 60 in the sixth mode. For example, the second detection control module 30 may set the third multiplexer 60 in the sixth mode using the signal 9 in FIG. 3. In this way, the control signal bus between the protected module 10 and the post-stage module may be conducted. Accordingly, the real output control signal output by the protected module 10 based on the real input control signal may be transmitted normally to the post-stage module. In response to receiving the real output control signal, the post-stage module may normally receive data output by the protected module 10 for the real input data.

In embodiments of this disclosure, in case the current state of the protected module 10 is the operating state, by setting the second multiplexer 50 to the sixth mode adapted to the operating state, the data output by the protected module 10 for the real input data are enabled to be successfully transmitted to the post-stage module of the protected module 10, which facilitates guaranteeing normal operation of a chip where the post-stage module is located.

In some optional examples, as shown in FIG. 3, the protection circuit further may include:
a conflict detection module 70, configured for obtaining the transmission signal on the control signal bus between the real control signal source and the protected module 10.

The first detection control module 15 is configured for, in response to the current state being the idle state, generating a test characterization signal.

The conflict detection module 70 is configured for: determining a receiving state of receiving the test characterization signal; determining a first attribute of existence of a real input control signal generated by the real control signal source in the transmission signal; and in response to the receiving state denoting that the test characterization signal is received, and the first attribute of existence denoting existence of the real input control signal in the transmission signal, generating signal conflict indication information.

Optionally, the conflict detection module 70 may be a module configured for detecting whether there is any conflict between timing of normal operation of the protected module 10 and of the abnormality detection.

Optionally, there may be a control signal bus between the real control signal source and the protected module 10, and the conflict detection module 70 may be in electrical connection with the control signal bus. In this way, the conflict detection module 70 may obtain a transmission signal on the control signal bus. In addition, the first detection control module 15 may be in electrical connection with the conflict detection module 70. If the current state of the protected module 10 is the idle state, the first detection control module 15 may generate the test characterization signal, wherein the test characterization signal may denote that abnormality detection is being performed on the protected module 10. As an example, the test characterization signal may be a signal 10 in FIG. 3. The first detection control module 15 may transmit the test characterization signal to the conflict detection module 70. If the current state of the protected module 10 is the operating state, the first detection control module 15 may not generate and transmit the test characterization signal. The conflict detection module 70 may determine the receiving state of receiving the test characterization signal, wherein the receiving state may denote whether the test characterization signal is received. The conflict detection module 70 further may determine the first attribute of existence of the real input control signal generated by the real control signal source in the transmission signal. The first attribute of existence may denote whether the real input control signal exists in the transmission signal. As an example, the real input control signal may be the signal 1 in FIG. 3.

If both conditions are met, i.e., the receiving state denotes that the test characterization signal is received, and the first attribute of existence denotes existence of the real input control signal in the transmission signal, it may be determined that normal operation of the protected module 10 and the abnormality detection are being performed simultaneously. That is, there is a conflict between timing of normal operation of the protected module 10 and of the abnormality detection. Then, the conflict detection module 70 may generate the signal conflict indication information. The conflict detection module 70 may report the signal conflict indication information to an upper-layer abnormality collecting module.

If at least one of the two conditions, i.e., the receiving state denoting that the test characterization signal is received, and the first attribute of existence denoting existence of the real input control signal in the transmission signal, is not met, it may be determined that normal operation of the protected module 10 and the abnormality detection are not being performed simultaneously. Then, the conflict detection module 70 may not generate the signal conflict indication information.

In embodiments of this disclosure, collaborative operation of the conflict detection module 70 and the first detection control module 15, etc., enables to effectively identify a case when there is a conflict between timing of normal operation of the protected module 10 and of the abnormality detection, and an indication of the case is provided, which facilitates avoiding an adverse impact caused by a conflict between timing of normal operation of the protected module 10 and of the abnormality detection, such as avoiding impact of the timing conflict on correctness of data received by the post-stage module.

In some optional examples, there may be a plurality of protected modules 10.

The first detection control module 15 is configured for determining a fault detection order for the plurality of protected modules 10.

The generation module 20 is configured for generating the test input data in response to the current state being the idle state, including:

The generation module 20 is configured for, in response to the current state being the idle state, generating test input data corresponding respectively to the plurality of protected modules 10.

The second detection control module 30 is configured for determining the abnormality detection result for the protected module 10 based on the actual test output data output by the protected module 10 for the test input data, and the expected test output data corresponding to the test input data, including:
the second detection control module 30 is configured for determining abnormality detection results corresponding respectively to the plurality of protected modules 10 according to the fault detection order, based on actual test output data corresponding respectively to the plurality of protected modules 10 and expected test output data corresponding respectively to the plurality of protected modules 10;
a sum of abnormality detection durations corresponding respectively to the plurality of protected modules 10 and a preset fault tolerance time interval meet a preset numerical relation.

Note that a maximum tolerance time interval for discovering and reporting abnormality is specified in a functional safety related standard, and the maximum tolerance time interval may be set to be the preset fault tolerance time interval. The preset fault tolerance time interval also may be referred to as FTTI. As an example, the functional safety related standard may be ISO26262, the preset fault tolerance time interval may be 132 milliseconds.

Optionally, there may be two, three, four, or more than four protected modules 10, without exhaustive enumeration of possible numbers here.

Taking a case of N protected modules 10 as an example, if current states of the N protected modules 10 respectively are the idle state, the generation module 20 may generate test input data corresponding respectively to the N protected modules 10. Test input data corresponding respectively to any two of the protected modules 10 may or may not be identical.

The first detection control module 15 may determine the fault detection order for the N protected modules 10. The fault detection order for the N protected modules 10 may be determined randomly, as long as it is guaranteed that abnormality detection is performed on the N protected modules 10 at different periods of time.

The second detection control module 30 may determine abnormality detection results corresponding respectively to the N protected modules 10 according to the fault detection order, based on actual test output data corresponding respectively to the N protected modules 10 and expected test output data corresponding respectively to the N protected modules 10. For example, the N protected modules 10 are denoted by a module 1, a module 2, ..., and a module N. Then, abnormality detection may be performed first on the module 1, to obtain an abnormality detection result corresponding to the module 1; then performed on the module 2, to obtain an abnormality detection result corresponding to the module 2;...; and finally performed on the module N, to obtain an abnormality detection result corresponding to the module N, as long as it is guaranteed that the sum of abnormality detection durations corresponding respectively to the module 1, the module 2, ..., and the module N, and the preset fault tolerance time interval, meet the preset numerical relation. That the sum and the preset fault tolerance time interval meet the preset numerical relation may refer to that a difference between the preset fault tolerance time interval and the sum is less than a preset duration difference. Alternatively, that the sum and the preset fault tolerance time interval meet the preset numerical relation may refer to that a ratio of the sum to the preset fault tolerance time interval is less than or equal to a preset ratio. As an example, the preset duration difference may be 20 milliseconds, 25 milliseconds, etc., and the preset ratio may be 0.6, 0.7, etc., without exhaustive enumeration of possible numbers here.

In embodiments of this disclosure, one protection circuit may be reused for protecting the N protected modules 10. In a respective intermittent period of normal operation of the protected modules 10, by time-division multiplexing of the one protection circuit, abnormality detection is enabled on the N protected modules 10, which facilitates lowering a hardware cost of abnormality detection.

In some optional examples, the first detection control module 15 is configured for determining the current state of the protected module 10 based on the transmission signal on the control signal bus between the real control signal source and the protected module 10, including:
the first detection control module 15 is configured for determining a second attribute of existence of a data frame ending signal in the transmission signal on the control signal bus between the real control signal source and the protected module 10, and determining the current state of the protected module 10 based on the second attribute of existence.

Optionally, there may be a control signal bus between the real control signal source and the protected module 10, and the first detection control module 15 may be in electrical connection with the control signal bus. In this way, the first detection control module 15 may obtain a transmission signal on the control signal bus. The first detection control module 15 may determine the second attribute of existence of the data frame ending signal in the transmission signal. The second attribute of existence may denote whether the data frame ending signal exists in the transmission signal. If the second attribute of existence denotes that the data frame ending signal exists in the transmission signal, this illustrates that normal operation of the protected module 10 ends. Then, it may be determined that the current state of the protected module 10 is the idle state. If the second attribute of existence denotes that the data frame ending signal does not exist in the transmission signal, this illustrates that the protected module 10 is operating normally. Then, it may be determined that the current state of the protected module 10 is the operating state.

In embodiments of this disclosure, by referring to the second attribute of existence of the data frame ending signal in the transmission signal on the control signal bus between the real control signal source and the protected module 10, it is enabled to efficiently and quickly determine the current state of the protected module 10.

In some optional examples, as shown in FIG. 3, the protection circuit may include the first detection control module 15, the generation module 20, the second detection control module 30, the first multiplexer 40, the second multiplexer 50, the third multiplexer 60, and the conflict detection module 70.

The first detection control module 15 may obtain the transmission signal on the control signal bus between the real control signal source and the protected module 10, and may determine the current state of the protected module 10 based on whether the data frame ending signal exists in the obtained transmission signal. For example, if it is monitored that the data frame ending signal exists in the obtained transmission signal, the current state of the protected module 10 may be determined to be the idle state. Then, abnormality detection on the protected module 10 may start. After a current round of abnormality detection ends, await a next data frame ending signal, to start, upon arrival of the next data frame ending signal, a next abnormality detection on the protected module 10.

The first detection control module 15 may be configured for generating the signal 5, the signal 7, the signal 2, the signal 10, and a signal 11. The signal 2 may be a signal configured for triggering generation of the test input data and the test input control signal by the generation module 20. The signal 5 may be a signal configured for controlling the mode of the first multiplexer 40. The signal 7 may be a signal configured for controlling a mode of the second multiplexer 50. If the current state of the protected module 10 is the idle state, the signal 5 may be configured for setting the first multiplexer 40 to the first mode, and the signal 7 may be configured for setting the second multiplexer 50 to the third mode. In this way, the test input data are enabled to be transmitted through the first multiplexer 40 to the protected module 10, and the test input control signal may be transmitted through the second multiplexer 50 to the protected module 10. If the current state of the protected module 10 is the operating state, the signal 5 may be configured for setting the first multiplexer 40 to the second mode, and the signal 7 may be configured for setting the second multiplexer 50 to the fourth mode. In this way, the real input data are enabled to be transmitted through the first multiplexer 40 to the protected module 10, and the real input control signal may be transmitted through the second multiplexer 50 to the protected module 10. The signal 10 may be a signal configured for denoting that abnormality detection is being performed on the protected module 10, i.e., the test characterization signal described above. The signal 11 may be a signal configured for instructing to compare consistency between the actual test output data which are output by the protected module 10 and the expected test output data.

If the conflict detection module 70 receives both the signal 1 and the signal 10, this illustrates a conflict between timing of normal operation of the protected module 10 and of the abnormality detection, in which case the conflict detection module 70 may generate the signal conflict indication information.

The second detection control module 30 may be configured for receiving the signal 11, a signal 12, and a signal 13, and further configured for generating the signal 8 and the signal 9. The signal 12 may be a signal carrying data output by the protected module 10. The signal 13 is a control signal output by the protected module 10. The signal 8 is the output blocking control signal. The signal 9 is a signal configured for controlling a mode of the third multiplexer 60. If the current state of the protected module 10 is the idle state, the signal 9 may be configured for setting the third multiplexer 60 to the fifth mode. In this way, the actual test output data are not to be transmitted to the post-stage module of the protected module 10. If the current state of the protected module 10 is the operating state, the signal 9 may be configured for setting the third multiplexer 60 to the sixth mode, to enable data output by the protected module 10 for the real input data to be transmitted to the post-stage module of the protected module 10.

Note that in case of time-division multiplexing of the protection circuit for protecting the N protected modules 10, first multiplexers 40 and second multiplexers 50 corresponding respectively to the N protected modules 10 are to be set.

To sum up, using embodiments of this disclosure, it is enabled to effectively implement abnormality detection on the protected module 10 with a simple circuit structure and low overhead, which facilitates guaranteeing chip reliability.

### Illustrative method

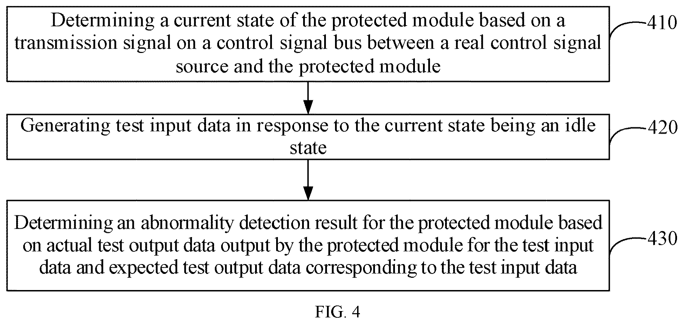

FIG. 4 is a flowchart of a method for protecting a protected module according to some illustrative embodiments of this disclosure. The method shown in FIG. 4 may include step 410, step 420, and step 430.

Step 410, Determining a current state of the protected module based on a transmission signal on a control signal bus between a real control signal source and the protected module.

Step 420, Generating test input data in response to the current state being an idle state.

Step 430, Determining an abnormality detection result for the protected module based on actual test output data output by the protected module for the test input data and expected test output data corresponding to the test input data.

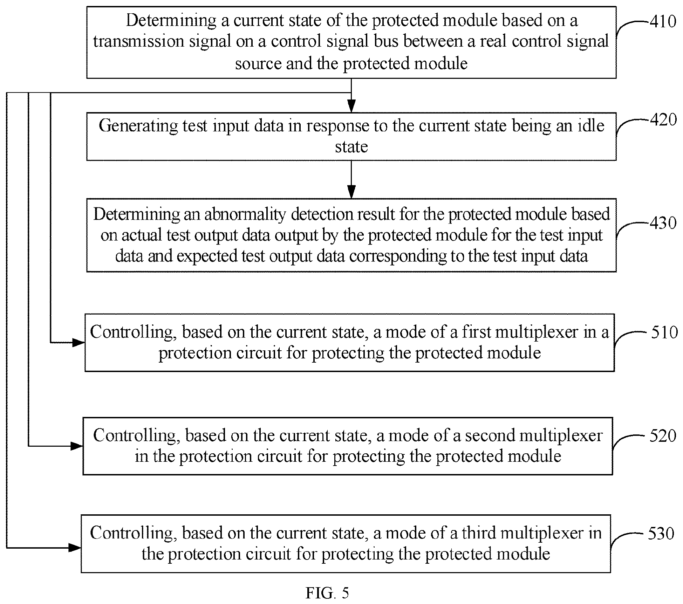

In some optional examples, the method according to embodiments of this disclosure further may include at least one of step 510, step 520, and step 530 in FIG. 5.

Step 510, Controlling, based on the current state, a mode of a first multiplexer in a protection circuit for protecting the protected module.

In some optional implementations of this disclosure, step 510 may include:
in response to the current state being the idle state, setting a first multiplexer to a first mode, to enable the protected module to receive the test input data generated by the generation module. The first multiplexer in the first mode conducts a data signal bus between the generation module in the protection circuit and the protected module.

In some other optional implementations of this disclosure, step 510 may include:
in response to the current state being an operating state, setting the first multiplexer to a second mode, to enable the protected module to receive real input data coming from the real data source, wherein the first multiplexer in the second mode conducts a data signal bus between a real data source and the protected module.

Step 520, Controlling, based on the current state, a mode of a second multiplexer in the protection circuit for protecting the protected module.

In some optional implementations of this disclosure, step 520 may include:
in response to the current state being the idle state, setting the second multiplexer to a third mode, to enable the protected module to receive the test input control signal generated by the generation module, wherein the second multiplexer in the third mode conducts a control signal bus between the generation module in the protection circuit and the protected module the control signal bus.

In some other optional implementations of this disclosure, step 520 may include:
in response to the current state being an operating state, setting the second multiplexer to a fourth mode, to enable the protected module to receive a real input control signal coming from the real control signal source, wherein the second multiplexer in the fourth mode conducts the control signal bus between the real control signal source and the protected module.

Step 530, Controlling, based on the current state, a mode of a third multiplexer in the protection circuit for protecting the protected module.

In some optional implementations of this disclosure, step 530 may include:
in response to the current state being the idle state, setting the third multiplexer to a fifth mode, to enable the post-stage module to receive the output blocking control signal generated by the second detection control module, such that in response to the output blocking control signal, the post-stage module blocks the actual test output data which are output by the protected module for the test input data. The third multiplexer in the fifth mode conducts a control signal bus between the second detection control module in the protection circuit and a post-stage module of the protected module.

In some other optional implementations of this disclosure, step 530 may include:
in response to the current state being an operating state, setting the third multiplexer to a sixth mode, to enable the post-stage module to receive a real output control signal output by the protected module, wherein the third multiplexer in the sixth mode conducts a control signal bus between the protected module and a post-stage module of the protected module.

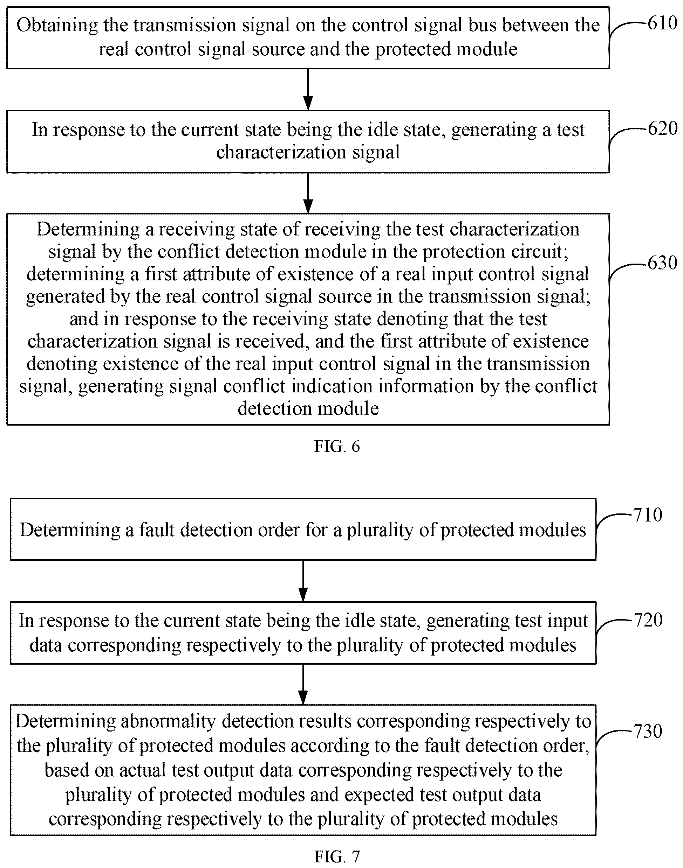

In some optional examples, as shown in FIG. 6, the method according to embodiments of this disclosure may include step 610, step 620, and step 630.

Step 610, Obtaining the transmission signal on the control signal bus between the real control signal source and the protected module.

Step 620, In response to the current state being the idle state, generating a test characterization signal.

Step 630, Determining a receiving state of receiving the test characterization signal by the conflict detection module in the protection circuit; determining a first attribute of existence of a real input control signal generated by the real control signal source in the transmission signal; and in response to the receiving state denoting that the test characterization signal is received, and the first attribute of existence denoting existence of the real input control signal in the transmission signal, generating signal conflict indication information.

In some optional examples, as shown in FIG. 7, the method according to embodiments of this disclosure may include step 710, step 720, and step 730. Optionally, step 720 may serve as an optional implementation of step 420 according to this disclosure. In addition, step 730 may serve as an optional implementation of according to this disclosure step 430.

Step 710, Determining a fault detection order for a plurality of protected modules.

Step 720, In response to the current state being the idle state, generating test input data corresponding respectively to the plurality of protected modules.

Step 730, Determining abnormality detection results corresponding respectively to the plurality of protected modules according to the fault detection order, based on actual test output data corresponding respectively to the plurality of protected modules and expected test output data corresponding respectively to the plurality of protected modules.

In some optional examples, step 410 may include:
determining a second attribute of existence of a data frame ending signal in the transmission signal on the control signal bus between the real control signal source and the protected module, and determining the current state of the protected module based on the second attribute of existence.

In the method according to this disclosure, various optional embodiments, optional implementations, and optional examples disclosed in the "Illustrative circuit" section described above may be flexibly selected and combined as needed, thereby implementing respective functions and effects, which are not exhaustively enumerated in this disclosure.

For beneficial technical effects corresponding to the illustrative embodiments of this method, one may refer to the respective beneficial technical effects in the "Illustrative circuit" section described above, which are not repeated here.

### Illustrative electronic device

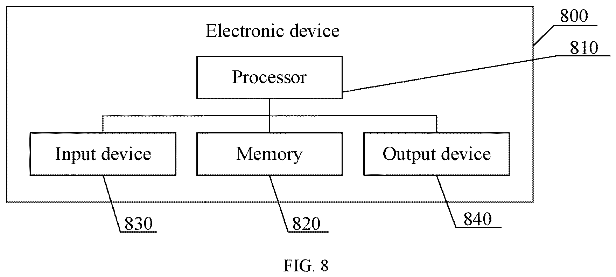

FIG. 8 illustrates a block diagram of an electronic device according to embodiments of this disclosure. The electronic device 800 includes one or more processors 810 and a memory 820.

The processor 810 may be a central processing unit (CPU) or another form of processing unit having a data processing capability and/or an instruction execution capability, and may control other components in the electronic device 800 to implement desired functions.

The memory 820 may include one or more computer program products, which may include various forms of computer readable storage media, such as a volatile memory and/or a non-volatile memory. The volatile memory may include, for example, random access memory (RAM) and/or cache. The nonvolatile memory may include, for example, read-only memory (ROM), hard disk, and flash memory. One or more computer program instructions may be stored on the computer readable storage medium. The processor 810 may execute the one or more computer program instructions to implement the method according to the various embodiments of this disclosure that are described above and/or other desired functions.

In an example, the electronic device 800 may further include an input device 830 and an output device 840. These components are connected to each other through a bus system and/or another form of connection mechanism (not shown).

The input device 830 may further include, for example, a keyboard and a mouse.

The output device 840 may output various information to the outside, and the output device may include, for example, a display, a speaker, a printer, a communication network, and a remote output device connected to the communication network.

Certainly, for simplicity, FIG. 8 shows only some of components in the electronic device 800 that are related to this disclosure, and components such as a bus and an input/output interface are omitted. In addition, according to specific application situations, the electronic device 800 may further include any other appropriate components.

Illustrative computer program product and computer readable storage medium

In addition to the foregoing method and device, embodiments of this disclosure may also be a computer program product, which includes computer program instructions. When the instructions are run by a processor, the processor may perform the steps, of the method according to the embodiments of this disclosure, that are described in the "Illustrative method" section of this specification.

The computer program product may be program code, written with one or any combination of a plurality of programming languages, that is configured to perform the operations in the embodiments of this disclosure. The programming languages include an object-oriented programming language such as Java or C++, and further include a conventional procedural programming language such as a "C" language or a similar programming language. The program code may be entirely or partially executed on a user computing device, executed as an independent software package, partially executed on the user computing device and partially executed on a remote computing device, or entirely executed on the remote computing device or a server.

In addition, the embodiments of this disclosure may further relate to a computer readable storage medium, which stores computer program instructions. When the computer program instructions are run by the processor, the processor may perform the steps, of the method according to the embodiments of this disclosure, that are described in the "Illustrative method" section of this specification.

The computer readable storage medium may be one readable medium or any combination of a plurality of readable media. The readable medium may be a readable signal medium or a readable storage medium. The readable storage medium may include, for example but is not limited to electricity, magnetism, light, electromagnetism, infrared ray, or a semiconductor system, an apparatus, or a device, or any combination of the above. More specific examples (a non-exhaustive list) of the readable storage medium include: an electrical connection having one or more conducting wires, a portable disk, a hard disk, a random access memory (RAM), a read-only memory (ROM), an erasable programmable read-only memory (EPROM or a flash memory), an optical fiber, a portable compact disk read-only memory (CD-ROM), an optical storage device, a magnetic storage device, or any suitable combination of the above.

Basic principles of this disclosure are described above in combination with specific embodiments. However, advantages, superiorities, effects, etc., mentioned in this disclosure are merely examples but are not for limitation, and it cannot be considered that these advantages, superiorities, effects, etc., are necessary for each embodiment of this disclosure. Specific details described above are merely for examples and for ease of understanding, rather than limitations. The details described above do not limit that this disclosure must be implemented by using the foregoing specific details.

A person skilled in the art may make various modifications and variations to this disclosure without departing from the spirit and the scope of this application. In this way, if these modifications and variations of this application fall within the scope of the claims and equivalent technologies of the claims of this disclosure, this disclosure also intends to include these modifications and variations.

## Claims

1. A protection circuit for a protected module, **characterized in that** the protection circuit comprises:
a first detection control module (15), configured for determining a current state of the protected module based on a transmission signal on a control signal bus between a real control signal source and the protected module;
a generation module (20), configured for generating test input data in response to the current state being an idle state; and
a second detection control module (30), configured for determining an abnormality detection result for the protected module based on actual test output data output by the protected module for the test input data and expected test output data corresponding to the test input data.

2. The protection circuit according to claim 1, further comprising:
a first multiplexer (40), configured for conducting, in a first mode, a data signal bus between the generation module (20) and the protected module, wherein
the first detection control module (15) is configured for, in response to the current state being the idle state, setting the first multiplexer (40) to the first mode, to enable the protected module to receive the test input data generated by the generation module (20).

3. The protection circuit according to claim 1, further comprising:
a first multiplexer (40), configured for conducting, in a second mode, a data signal bus between a real data source and the protected module, wherein
the first detection control module (15) is configured for, in response to the current state being an operating state, setting the first multiplexer (40) to the second mode, to enable the protected module to receive real input data coming from the real data source.

4. The protection circuit according to claim 1, further comprising:
a second multiplexer (50), configured for conducting, in a third mode, a control signal bus between the generation module (20) and the protected module, wherein
the generation module (20) is configured for, in response to the current state being the idle state, generating a test input control signal corresponding to the test input data; and
the first detection control module (15) is configured for, in response to the current state being the idle state, setting the second multiplexer (50) to the third mode, to enable the protected module to receive the test input control signal generated by the generation module (20).

5. The protection circuit according to claim 1, further comprising:
a second multiplexer (50), configured for conducting, in a fourth mode, the control signal bus between the real control signal source and the protected module, wherein
the first detection control module (15) is configured for, in response to the current state being an operating state, setting the second multiplexer (50) to the fourth mode, to enable the protected module to receive a real input control signal coming from the real control signal source.

6. The protection circuit according to claim 1, further comprising:
a third multiplexer (60), configured for conducting, in a fifth mode, a control signal bus between the second detection control module (30) and a post-stage module of the protected module, wherein
the second detection control module (30) is configured for generating an output blocking control signal, and in response to the current state being the idle state, setting the third multiplexer (60) to the fifth mode, to enable the post-stage module to receive the output blocking control signal generated by the second detection control module (30), such that in response to the output blocking control signal, the post-stage module blocks the actual test output data which are output by the protected module for the test input data.

7. The protection circuit according to claim 1, further comprising:
a third multiplexer (60), configured for conducting, in a sixth mode, a control signal bus between the protected module and a post-stage module of the protected module, wherein
the second detection control module (30) is configured for in response to the current state being an operating state, setting the third multiplexer (60) to the sixth mode, to enable the post-stage module to receive a real output control signal output by the protected module.

8. The protection circuit according to any one of claims 1 to 7, further comprising:
a conflict detection module (70), configured for obtaining the transmission signal on the control signal bus between the real control signal source and the protected module, wherein
the first detection control module (15) is configured for, in response to the current state being the idle state, generating a test characterization signal; and
the conflict detection module (70) is configured for: determining a receiving state of receiving the test characterization signal; determining a first attribute of existence of a real input control signal generated by the real control signal source in the transmission signal; and in response to the receiving state denoting that the test characterization signal is received, and the first attribute of existence denoting existence of the real input control signal in the transmission signal, generating signal conflict indication information.

9. The protection circuit according to any one of claims 1 to 7, wherein
the first detection control module (15) is configured for determining a fault detection order for a plurality of protected modules,
the generation module (20) is configured for generating the test input data in response to the current state being the idle state, comprising:
the generation module (20) is configured for, in response to the current state being the idle state, generating test input data corresponding respectively to the plurality of protected modules, and
the second detection control module (30) is configured for determining the abnormality detection result for the protected module based on the actual test output data output by the protected module for the test input data and the expected test output data corresponding to the test input data, comprising:
the second detection control module (30) is configured for determining abnormality detection results corresponding respectively to the plurality of protected modules according to the fault detection order, based on actual test output data corresponding respectively to the plurality of protected modules and expected test output data corresponding respectively to the plurality of protected modules,
wherein a sum of abnormality detection durations corresponding respectively to the plurality of protected modules and a preset fault tolerance time interval meet a preset numerical relation.

10. The protection circuit according to any one of claims 1 to 7, wherein the first detection control module (15) is configured for determining the current state of the protected module based on the transmission signal on the control signal bus between the real control signal source and the protected module, comprising:
the first detection control module (15) is configured for determining a second attribute of existence of a data frame ending signal in the transmission signal on the control signal bus between the real control signal source and the protected module, and determining the current state of the protected module based on the second attribute of existence.

11. A method for protecting a protected module, **characterized in that** the method comprises:
determining (410) a current state of the protected module based on a transmission signal on a control signal bus between a real control signal source and the protected module;
generating (420) test input data in response to the current state being an idle state; and
determining (430) an abnormality detection result for the protected module based on actual test output data output by the protected module for the test input data and expected test output data corresponding to the test input data.

12. The method according to claim 11, further comprising at least one of:
controlling (510), based on the current state, a mode of a first multiplexer in a protection circuit for protecting the protected module;
controlling (520), based on the current state, a mode of a second multiplexer in the protection circuit for protecting the protected module; and
controlling (530), based on the current state, a mode of a third multiplexer in the protection circuit for protecting the protected module.

13. The method according to claim 11, further comprising:
obtaining (610) the transmission signal on the control signal bus between the real control signal source and the protected module;
in response to the current state being the idle state, generating (620) a test characterization signal; and
determining (630) a receiving state of receiving the test characterization signal by the conflict detection module in the protection circuit; determining a first attribute of existence of a real input control signal generated by the real control signal source in the transmission signal; and in response to the receiving state denoting that the test characterization signal is received, and the first attribute of existence denoting existence of the real input control signal in the transmission signal, generating signal conflict indication information.

14. A computer readable storage medium, wherein the storage medium stores a computer program, when executed by a processor, causes the processor to implement the method according to any one of claims 11 to 13.

15. An electronic device (800), **characterized in that** the electronic device comprises:
a processor (810); and
a memory (820), configured to store processor-executable instructions, wherein
the processor (810) is configured to read the executable instructions from the memory (820), and execute the instructions to implement the method for protecting a protected module according to any one of claims 11 to 13.
